# EUROPÄISCHE PATENTSCHRIFT

(11) **EP 0 471 975 B1**
(45) Veröffentlichungstag und Bekanntmachung des Hinweises auf die Patenterteilung: **07.02.1996**
(21) Anmeldenummer: 91111761.2
(22) Anmeldetag: 15.07.1991
(51) Int. Cl.: C04B 35/00, C25F 5/00, H01L 39/24, B22D 29/00

(54) **Verfahren zur Herstellung von Formkörpern aus Vorstufen oxidischer Hochtemperatursupraleiter**
Process for producing bodies from preforms of oxide high temperature superconductors
Procédé pour la production de corps supraconducteurs à haute température en oxyde façonnés à partir de préformes

(30) Priorität: 17.08.1990 DE 4026014
(43) Veröffentlichungstag der Anmeldung: 26.02.1992
(73) Patentinhaber: HOECHST AKTIENGESELLSCHAFT, D-65926 Frankfurt am Main (DE)
(72) Erfinder: Preisler, Eberhard, Dr., W-5042 Erftstadt (DE); Bock, Joachim, Dr., W-5042 Erftstadt (DE)

(56) Entgegenhaltungen:
- EP-A- 0 362 492
- DD-A- 59 149

## Beschreibung

Die Schmelzsynthese von Hochtemperatursupraleitermaterialien auf der Basis der Bismut-Strontium-Calciumcuprate ist in DE 38 30 092 A1 beschrieben. Die danach oder auf andere bekannte Weise herstellbaren "BSCCO" Hochtemperatursupraleiter haben die Zusammensetzung Bi₂(Sr,Ca)₃Cu₂Oₓ ("2-Schichtverbindung"), wobei das Verhältnis von Strontium zu Calcium (2 bis 5) : 1 beträgt (BSCCO steht für Bismut-Strontium-Calcium-Kupfer-Oxid). Außerdem sind "1-Schichtverbindungen" Bi₂(Sr,Ca)₂CuOₓ und "3-Schichtverbindungen" Bi₂(Sr,Ca)₄Cu₃Oₓ als BSCCO-Hochtemperatur-Supraleiter bekannt. Der Sauerstoffindex "x" ist durch die Summe der Wertigkeiten von Bi, Sr, Ca und Cu vorgegeben, aber insoweit variabel, als Bi 3- oder 5-wertig und Cu 1- oder 2-wertig sein können.

In der DE 38 30 092 A1 ist auch die Herstellung von Formkörpern aus den Bismut-Strontium-Calciumcupraten erwähnt. Solche Formkörper lassen sich z.B. durch Vergießen in unterschiedlich geformte Kokillen, die vorzugsweise aus Kupfer bestehen, erhalten, wenn die Kokille offen ist - wie z. B. im Falle einer Mulde mit abgeschrägten Seitenwänden oder eines Halbzylinders - und der Form nach eine Entnahme des Gußstücks erlaubt. Wichtig ist auch, daß der Guß bei kalter Form vorgenommen wird, so daß die Abkühlung der erstarrenden Schmelze an der Kokillenwand so rasch erfolgt, daß eine chemische Reaktion mit dem Kupfer der Kokillenwand nicht eintritt. Auch wenn die Kokillenwand flexibel ist und z.B. aus einem dünnen Blech besteht, das nach dem Abkühlen weggebogen werden kann, gibt es keine Probleme.

Wesentlich schwieriger ist die Herstellung komplizierterer Formkörper, die eine weitgehend geschlossene Kokille mit gegebenenfalls komplizierter Form erforderlich machen. In solchen Fällen kann auch das Prinzip einer raschen Abkühlung zur Vermeidung der Wandreaktion nicht immer angewendet werden, weil gegebenenfalls die Kokille vorgeheizt werden muß, um eine zu frühe Erstarrung der einfließenden Schmelze zu vermeiden. In vergleichsweise einfachen Fällen, z.B. bei der Herstellung dickerer zylindrischer Formkörper durch Vergießen in eine rohrförmige Kokille, kann man noch an eine mechanische Entfernung des Mantelmaterials denken, etwa durch Auftrennen der Kokillenwand in 2 Halbschalen. Doch ist dies bereits bei geringeren Durchmessern kein interessantes Verfahren mehr und bei komplizierteren Geometrien wie Ringen oder Spulen nicht mehr anwendbar.

Um eine Schmelze der dem Hochtemperatur-Supraleiter entsprechenden Zusammensetzung nach dem Erstarren in den supraleitenden Zustand zu überführen, ist eine nachträgliche Wärmebehandlung der erstarrten Schmelze von 6 bis 30 Stunden Dauer bei Temperaturen um 800°C an Luft oder Sauerstoff notwendig. Es ist jedoch nur ein Metall bekannt, das als Hüllmaterial für BSCCO Hochtemperatur-Supraleiter geeignet und für Sauerstoff bei den Wärmebehandlungstemperaturen durchlässig ist und somit die Umwandlung der erstarrten Schmelze in den erwünschten Hochtemperatur-Supraleiter innerhalb der Metallhülle erlaubt: Silber. Leider liegt der Schmelzpunkt des Silbers mit 960,8°C unterhalb der Temperatur, die die Supraleiterschmelze haben muß, um zuverlässig vergossen werden zu können. So würde eine Silberform aufschmelzen, bevor die Supraleiterschmelze erstarrt ist.

Aus diesem Grunde ist man auf Kupferformen angewiesen, da Kupfer das einzige systemimmanente Metall ist, das sich für den vorliegenden Zweck eignet. Allerdings ist eine Entfernung des Kupfers von der erstarrten Schmelze zwingend notwendig.

Nachdem die mechanische Ablösung der Kupferform nur beschränkt praktizierbar ist, liegt deren chemische Auflösung nahe. Dies ist mit Hilfe einer oxidierenden Säure oder einer Säure plus Oxidationsmittel im Prinzip möglich. Versuche dieser Art sind im Zusammenhang mit der Untersuchung von Yttrium-Bariumcuprat-Supraleiterpulvern, die in Kupferrohre verfüllt und durch Tiefziehen und Walzen verdichtet worden waren, bekannt.

Will man jedoch auf gleiche Weise bei den auf Bismut basierenden Supraleitern verfahren, stellt man einen starken Angriff der Säure auch auf den Supraleiter bzw. seine Vorstufe der erstarrten Schmelze fest, sobald an einer Stelle der Kupfermantel aufgelöst und die Oberfläche der erstarrten Schmelze freigelegt ist. Es zeigt sich nämlich, daß die supraleitenden Bismutverbindungen säurelöslich sind.

Es ist Aufgabe der vorliegenden Erfindung, einen Weg anzugeben, der eine Auflösung des Kupfermantels erlaubt, ohne den darunterliegenden Supraleiter bzw. dessen Vorstufe nennenswert anzugreifen.

Diese Aufgabe wurde durch anodische Oxidation in verdünnter Schwefelsäure gelöst Das dieser Erfindung zugrundeliegende Prinzip ist die Ausbildung einer einen weiteren Angriff der Säure auf die supraleitende Verbindung unterdrückenden Schutzschicht aus Strontium- und/oder Calciumsulfat aus dem in der Schwefelsäure enthaltenen Sulfat und den in der Supraleiterverbindung enthaltenen Erdalkalimetallen.

Das vom Kupfermantel zu befreiende Formstück wird als Anode einer Elektrolysezelle zusammen mit einer Kupferkathode geschaltet. Nach Einschalten eines geeigneten Elektrolysestroms löst sich Kupfer aus dem Mantel auf, wobei gleichzeitig Kupfer an der Kathode wiederum abgeschieden wird. Auf diese Weise bleibt die Kupfermenge, die einen Teil der ursprünglich eingesetzten Schwefelsäure bindet, gering, so daß die Konzentration an freier Schwefelsäure ebenfalls sehr gering gehalten werden kann. Dies ist vorteilhaft hinsichtlich der Stabilität der Erdalkalisulfatschutzschicht auf dem freigelegten Formstück.

Im einzelnen betrifft die Erfindung nunmehr ein Verfahren zur Herstellung von Formkörpern aus Vorstufen oxidischer Hochtemperatursupraleiter vom Typ BSCCO, welches dadurch gekennzeichnet ist, daß man eine Kupferkokille der gewünschten Form, welche eine erstarrte Bismut-Strontium-Calciumcuprat-Schmelze umhüllt, in einem aus Anode, Kathode und einem Elektrolyten bestehenden Gleichstromkreis als Anode schaltet, als Elektrolyten eine verdünnte Schwefelsäure einsetzt, und den Elektrolyten bis zur Auflösung der als Anode geschalteten Kupferkokille und Freilegung des BSCCO-Formkörpers mit einem Gleichstrom von 1 bis 50 mA· cm⁻² beaufschlagt.

Darüberhinaus kann das Verfahren der Erfindung bevorzugt oder wahlweise dadurch gekennzeichnet sein, daß man
a) als Kathode einen oder mehrere Formkörper aus Kupfer verwendet;
b) die elektrolytische Auflösung der Kupferkokille bei 15 bis 70°C durchführt;
c) eine Kupferkokille als Anode schaltet, welche die erstarrte Bismut-Strontium-Calciumcuprat-Schmelze umhüllt und eine oder mehrere Öffnungen aufweist.

Die nachfolgende Zeichnung zeigt eine mögliche Anordnung zur Durchführung der Elektrolyse (anodische Oxidation). Das mit der erstarrten Supraleiterschmelze 1 gefüllte Kupferrohr 2 (Anode) taucht senkrecht in ein mit dem Elektrolyten (z. B. 20 %ige H₂SO₄) gefülltes Becherglas 3 ein. Die Anode 2 ist von zwei Kupferkathoden 4 umgeben, die ihrerseits über einen Galvano-Potentiostaten 5 mit der Anode 2 in Verbindung stehen. In das Becherglas 3 taucht außerdem ein Kontaktthermometer 6 ein, das den heizbaren Magnetrührer 7 steuert, auf dem das Becherglas 3 steht.

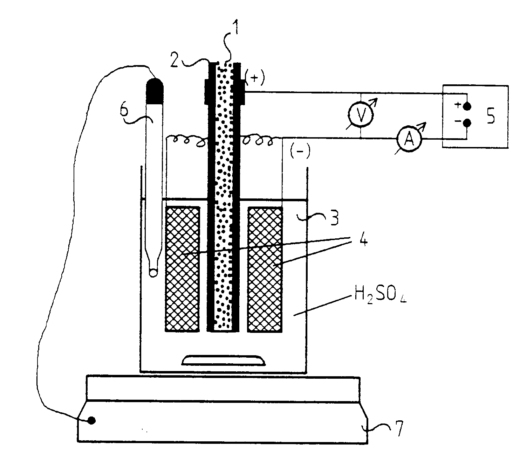

Durch Schaltung des den Supraleiterkern enthaltenden Formteils als Anode einer Elektrolysezelle gemäß der Zeichnung wird beim Aufgeben eines Stroms Kupfer anodisch aufgelöst und kathodisch wieder abgeschieden. Dieser Vorgang ist allerdings erst bei einer Mindestkonzentration von Cu im Elektrolyten gegeben, vorher scheidet sich an der Kathode Wasserstoff ab. Die Kupferabscheidung an der Kathode hat den Vorteil, daß die Schwefelsäurekonzentration relativ niedrig gewählt werden kann, da sich die Schwefelsäure im wesentlichen nicht verbraucht. Es ist auch hier möglich, die Elektrolyse bei etwas höherer Temperatur, z.B. 50°C durchzuführen, wobei die Reaktionsüberspannungen vermindert werden. Kupfer scheidet sich dann auf der Kathode nicht als Schwamm, wie bei Raumtemperatur, sondern in ziemlich dichter Form ab, wodurch die Gefahr eines Kurzschlusses zwischen den Elektroden praktisch entfällt. Bei einer Anodenstromdichte von 20 mA·cm⁻² und bei einer Badtemperatur von 40°C liegt die Betriebsspannung bei 0,2 V.

Obwohl der Supraleiterkern, der noch im ungetemperten und nicht mit Luft behandelten Zustand vorliegt, kein guter Elektronenleiter ist (der Raumtemperaturwiderstand liegt bei 1-3 Ohm cm), ist seine Leitfähigkeit doch groß genug, um den Kern so weit anodisch zu polarisieren, daß sich im Endstadium der Auflösung des Kupfermantels bildende Kupferinseln elektrisch nicht isoliert sind, sondern sich auch noch auflösen können, während bereits freiliegendes Kernmaterial durch den sich bildenden Erdalkalisulfatfilm geschützt ist. Außerdem erhöht der Sulfatfilm den Ohmwiderstand der freigelegten Kernoberfläche und reduziert damit den anodischen Strom an diesen Stellen.

Die Säurekonzentration und die Behandlungstemperatur sind nicht ausschlaggebend. Man kann beispielsweise mit 2 bis 35 gew%iger H₂SO₄ arbeiten. Die Menge der einzusetzenden, Sulfatanionen enthaltenden verdünnten Schwefelsäure kann an sich gering sein, es muß lediglich das Löslichkeitsprodukt von Calciumsulfat und Strontiumsulfat in Gegenwart von Schwefelsäure bei der gewählten Temperatur unter Bildung eines dichten Sulfat-Schutzfilms überschritten werden.

### Beispiel

Eine Spirale von 5 Windungen aus einem Kupferrohr mit einer Wandstärke von 0,8 mm und einer lichten Weite von 6 mm, die mit einer Schmelze aus einem Bismut-Strontium-Calcium-Cuprat-Supraleiter der Formel Bi₂Sr₂CaCu₂Oₓ gefüllt war, wurde in einem Becherglas als Anode geschaltet, während ein Kupferzylinder außen um die Spirale herum zusammen mit einem zusätzlichen Kupferstab im Zentrum der Spirale als Kathoden diente. Als Elektrolyt wurde 20 %ige Schwefelsäure verwendet. Die Elektrolyse wurde mit einer Stromdichte von 40 mA·cm⁻² bei Raumtemperatur durchgeführt und dauerte 20 Stunden. Danach war der Supraleiterkern, soweit er in den Elektrolyten eingetaucht war, weitgehend vom Kupfermantel befreit und mit einer dünnen, weißen Schicht überzogen. Es wurde kein Lochfraß beobachtet.

## Patentansprüche

1. Verfahren zur Herstellung von Formkörpern aus Vorstufen oxidischer Hochtemperatursupraleiter vom Typ BSCCO, dadurch gekennzeichnet, daß man eine weitgehend geschlossene Kupferkokille mit ggf. komplizierter Form, welche eine erstarrte Bismut-Strontium-Calciumcuprat-Schmelze umhüllt und eine oder mehrere Öffnungen aufweist, in einem aus Anode, Kathode und einem Elektrolyten bestehenden Gleichstromkreis als Anode schaltet, als Elektrolyten eine verdünnte Schwefelsäure einsetzt, und den Elektrolyten bis zur Auflösung der als Anode geschalteten Kupferkokille und Freilegung des BSCCO-Form-körpers mit einem Gleichstrom von 1 bis 50 mA cm⁻² beaufschlagt, wobei eine den weiteren Angriff der Schwefelsäure auf den Formkörper unterdrückende Schutzschicht aus Strontium- und/oder Calciumsulfat aus der zugegebenen Schwefelsäure und den in den Formkörpern enthaltenen Erdalkalioxiden gebildet wird.

2. Verfahren nach Anspruch 1, dadurch gekennzeichnet, daß man als Kathode einen oder mehrere Formkörper aus Kupfer verwendet.

3. Verfahren nach mindestens einem der vorhergehenden Ansprüche, dadurch gekennzeichnet, daß man die elektrolytische Auflösung der Kupferkokille bei 15 bis 70°C durchführt.

## Claims

1. A process for producing molded bodies from precursors of oxidic high-temperature superconductors of the BSCCO type, which comprises wiring a substantially closed copper mold having an optionally complicated shape which encloses a solidified bismuth strontium calcium cuprate melt and has one or more openings as anode in a direct current circuit composed of anode, cathode and an electrolyte, using a dilute sulfuric acid as electrolyte and subjecting the electrolyte to a direct current of 1 to 50 mA·cm⁻² until the copper mold wired as anode is dissolved and the BSCCO molded body is laid bare, a protective layer which suppresses further attack of the sulfuric acid on the molded body and is composed of strontium and/or calcium sulfate being formed from the sulfuric acid added and the alkaline earth metal oxides contained in the molded bodies.

2. A process as claimed in claim 1, wherein one or more molded bodies composed of copper are used as cathode.

3. A process as claimed in claim 1, wherein the electrolytic dissolution of the copper mold is carried out at 15 to 70°C.

## Revendications

1. Procédé de fabrication de corps moulés à partir de géniteurs de supraconducteurs haute température oxydiques du type BSCCO, caractérisé en ce qu'on monte en tant qu'anode une coquille de cuivre largement fermée, de forme éventuellement compliquée, enveloppant une masse fondue solidifiée de bismuth-strontium-calcium-cuprate et présentant une ou plusieurs ouvertures, dans un circuit à courant continu composé d'une anode, d'une cathode et d'un électrolyte, qu'on utilise de l'acide sulfurique dilué comme électrolyte et qu'on applique à l'électrolyte un courant continu de 1 à 50 mA cm⁻² jusqu'à dissolution de la coquille de cuivre montée en tant qu'anode et mise à nu du corps moulé en BSCCO, une couche protectrice en sulfate de strontium et/ou sulfate de calcium inhibant la poursuite de l'attaque de l'acide sur le corps moulé étant formée à partir de l'acide sulfurique ajouté et des oxydes de métaux alcalino-terreux contenus dans les corps moulés.

2. Procédé selon la revendication 1, caractérisé en ce qu'on utilise comme cathode un ou plusieurs corps moulés en cuivre.

3. Procédé selon au moins l'une des revendications précédentes, caractérisé en ce qu'on procéde à la dissolution électrolytique de la coquille de cuivre entre 15 et 70°C.
